# EUROPEAN PATENT APPLICATION

(11) **EP 4 797 898 A1**
(43) Date of publication of application: **26.08.2026**
(21) Application number: 25220055.5
(22) Date of filing: 02.12.2025
(51) Int. Cl.: H10B 20/25, G11C 17/14, H10D 30/67, H10W 20/49

(54) **HORIZONTAL MEMORY STRUCTURES IN LOGIC DEVICES AND METHODS OF MANUFACTURING THE SAME**

(30) Priority: 25.02.2025 US 202563762831 P; 18.09.2025 US 202519332209
(71) Applicant: Samsung Electronics Co., Ltd., Suwon-si, Gyeonggi-do 16677 (KR)
(72) Inventor: SHIN, Jongmin, San Jose, CA 95134 (US); LIM, Jinyoung, San Jose, CA 95134 (US); PARK, Young Gook, San Jose, CA 95134 (US); KIM, Gwang-Sik, San Jose, CA 95134 (US); PARK, Beomjin, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

A circuit device (100) includes a semiconductor substrate (102) having a first transistor structure (104). The first transistor structure includes at least one first channel region (106) extending between first source/drain regions (108), first source/drain contacts (110) on the first source/drain regions, respectively, and a first gate (112) on the at least one channel region between the first source/drain contacts. A first spacer (115) electrically isolates one of the first source/drain regions from one of the first source/drain contacts thereon. Related devices and fabrication methods are also discussed.

## Description

### FIELD

The present disclosure relates to circuit devices and methods of forming the same.

### BACKGROUND

The size of transistors in integrated circuit devices has continued to decrease in order to maintain downscaling of logic elements. Technology to increase transistor density and concentrate more transistors within the same area and improve the performance of transistors continues to be developed.

The size of transistors in integrated circuit devices has continued to decrease in order to maintain downscaling of logic elements. Technology to increase transistor density and concentrate more transistors within the same area and improve the performance of transistors continues to be developed. For example, as transistor density is increased, a gate extension that does not land on or make connection to a gate contact may be a factor contributing to parasitic capacitance. In fin field effect transistors (finFETs), it may be challenging to reduce gate extension without affecting the channel width. However, in Gate-All-Around (GAA) devices, where channels are stacked vertically, it may be possible to reduce or minimize parasitic capacitance without substantially reducing the channel width. As such, three-dimensional (3D) device structures and related fabrication processes are under consideration.

### SUMMARY

Some embodiments of the present disclosure may provide circuit devices including logic and memory elements that are formed on a same substrate or wafer, using common fabrication processes (e.g., simultaneously, or otherwise using one or more of the same processing operations). For example, a circuit device may include a memory region and a logic region. In the memory region, at least a portion of a contact etch stop layer (CESL) may not be removed, and thus a spacer may be formed that electrically isolates or separates the source/drain (S/D) regions and the S/D contacts. In the logic region, the CESL may be removed, and thus the S/D contacts may be electrically coupled to the S/D regions. The spacer may extend between the gate and source/drain contacts, such that a memory cell may be formed between the gate and source/drain contacts (with the spacer material therebetween) in a horizontal or lateral direction. The circuit device may be implemented using one or more types of transistor structures, such as (but not limited to) planar FETs, finFETs, GAAFETs, and/or 3DSFETs.

According to some embodiments, a circuit device includes a semiconductor substrate comprising a first transistor structure. The first transistor structure includes at least one first channel region extending between first source/drain regions, first source/drain contacts on the first source/drain regions, respectively, a first gate on the at least one first channel region between the first source/drain contacts, and a first spacer that electrically isolates one of the first source/drain regions from one of the first source/drain contacts thereon.

In some embodiments, the first spacer comprises a dielectric material that extends between the one of the first source/drain contacts and the one of the first source/drain regions, and further extends between the first gate and the one of the first source/drain contacts.

In some embodiments, the first gate continuously extends in a first direction, at least one first channel region extends between the first source/drain regions in a second direction intersecting the first direction. A contact metal line extends in the second direction and is electrically connected to one selected from a group consisting of the first gate and the one of the first source/drain contacts.

In some embodiments, the first spacer comprises respective first spacers that extend between the first gate and the first source/drain contacts, and the contact metal line electrically connects the first source/drain contacts.

In some embodiments, the contact metal line electrically connects the first gate of the first transistor structure to a respective gate of at least one adjacent transistor structure in the semiconductor substrate.

In some embodiments, in the contact metal line electrically connects the one of the first source/drain contacts to a respective source/drain contact of at least one an adjacent transistor structure in the semiconductor substrate.

In some embodiments, the contact metal line comprises a bit line of the circuit device. A word line is electrically connected to another selected from the group consisting of the first gate and the one of the first source/drain contacts. The dielectric material is configured to break down in response to an applied voltage comprising a difference between a voltage applied to the bit line and a voltage applied to the word line.

In some embodiments, the dielectric material comprises silicon nitride, silicon oxide, aluminum oxide, or hafnium oxide.

In some embodiments, the dielectric material comprises a first dielectric layer and a second dielectric layer comprising a different dielectric material than the first dielectric layer.

In some embodiments, the dielectric material further comprises a third dielectric layer comprising a different dielectric material than the second dielectric layer, and the second dielectric layer is between the first dielectric layer and the third dielectric layer.

In some embodiments, the first transistor structure is in a memory region of the semiconductor substrate. The semiconductor substrate further includes a second transistor structure in a logic region of the semiconductor substrate that is adjacent the memory region. The second transistor structure includes at least one second channel region extending between second source/drain regions having second source/drain contacts directly thereon, respectively.

According to some embodiments, a circuit device includes a semiconductor substrate comprising a first transistor structure in a memory region of the semiconductor substrate and a second transistor structure in a logic region of the semiconductor substrate adjacent the memory region. The first transistor structure comprises at least one first channel region extending between first source/drain regions having first source/drain contacts thereon, respectively, and a first spacer that electrically isolates one of the first source/drain regions from one of the first source/drain contacts thereon. The second transistor structure comprises at least one second channel region extending between second source/drain regions having second source/drain contacts directly thereon, respectively.

In some embodiments, the first transistor structure further comprises a first gate on the at least one first channel region. The first spacer comprises a dielectric material that extends between the one of the first source/drain contacts and the one of the first source/drain regions, and further extends between the first gate and the one of the first source/drain contacts.

In some embodiments, the second transistor structure further comprises a second gate on the at least one second channel region. The first gate and the second gate continuously extend in a first direction. A contact metal line extends in a second direction intersecting the first direction and is electrically connected to one selected from a group consisting of the first gate and the one of the first source/drain contacts.

In some embodiments, the contact metal line comprises a bit line of the circuit device. A word line is electrically connected to another selected from the group consisting of the first gate and the one of the first source/drain contacts. The dielectric material is configured to break down in response to an applied voltage comprising a difference between a voltage applied to the bit line and a voltage applied to the word line.

According to some embodiments, a method of fabricating a circuit device includes providing a semiconductor substrate having a memory region and a logic region, forming first source/drain regions with at least one first channel region therebetween in the memory region and second source/drain regions with at least one second channel region therebetween in the logic region, forming a dielectric material on the memory region and the logic region of the semiconductor substrate, and forming first and second source/drain contacts on the first and second source/drain regions, respectively. The dielectric material on the memory region provides first spacers that electrically isolate the first source/drain regions from the first source/drain contacts thereon.

In some embodiments, the method further includes selectively removing portions of the dielectric material to define openings therein exposing the second source/drain regions in the logic region of the semiconductor substrate, where forming the first and second source/drain contacts comprises forming the second source/drain contacts in the openings in the dielectric material and directly on the second source/drain regions, respectively.

In some embodiments, the method further includes forming a first gate on the at least one first channel region and a second gate on the at least one second channel region. The first spacers extend between the first source/drain contacts and the first source/drain regions, and further extend between the first gate and the first source/drain contacts.

In some embodiments, the first gate and the second gate continuously extend in a first direction, and the at least one first channel region and the at least one second channel region extend in a second direction intersecting the first direction. The method further includes forming a contact metal line that extends in a second direction and is electrically connected to one selected from a group consisting of the first gate and one of the first source/drain contacts.

In some embodiments, the contact metal line comprises a bit line of the circuit device, and the method further includes forming a word line that is electrically connected to another selected from the group consisting of the first gate and the one of the first source/drain contacts. The dielectric material is configured to break down in response to an applied voltage comprising a difference between a voltage applied to the bit line and a voltage applied to the word line.

In some embodiments, the dielectric material comprises silicon nitride, silicon oxide, aluminum oxide, or hafnium oxide.

In some embodiments, the dielectric material comprises a first dielectric layer, and, before forming the first and second source/drain contacts, the method further includes selectively removing portions of the first dielectric layer to define openings therein that do not expose the first source/drain regions in the memory region, and forming a second dielectric layer in the openings in the first dielectric layer in the memory region, the second dielectric layer comprising a different dielectric material than the first dielectric layer.

In some embodiments, before forming the first and second source/drain contacts, the method further includes forming a third dielectric layer on the second dielectric layer in the openings in the first dielectric layer in the memory region, where the second dielectric layer is between the first dielectric layer and the third dielectric layer, and the third dielectric layer comprises a different dielectric material than the second dielectric layer.

Other devices, apparatus, and/or methods according to some embodiments will become apparent to one with skill in the art upon review of the following drawings and detailed description. It is intended that all such additional embodiments, in addition to any and all combinations of the above embodiments, be included within this description, be within the scope of the present disclosure, and be protected by the accompanying claims.

### BRIEF DESCRIPTION OF THE DRAWINGS

FIG. 1A is a schematic top or plan view and FIGS. 1B and 1C are schematic cross-sectional views (taken along lines 1B-1B and 1C-1C of FIG. 1A, respectively) illustrating example circuit devices including horizontal memory elements and logic elements on a same substrate according to some embodiments of the present disclosure.
FIGS. 2A and 2B are schematic cross-sectional views illustrating example operational states of circuit devices including horizontal memory elements with electrically connected source/drain contacts according to some embodiments of the present disclosure.
FIGS. 3A and 3B are schematic plan and cross-sectional views, respectively, illustrating example circuit devices including horizontal memory elements with electrically connected gate structures according to some embodiments of the present disclosure.
FIGS. 4A and 4B are schematic plan and cross-sectional views, respectively, illustrating example circuit devices including horizontal memory elements with electrically connected drain contacts (or source contacts) according to some embodiments of the present disclosure.
FIGS. 5A and 5B are schematic plan and cross-sectional views, respectively, illustrating example circuit devices including horizontal memory elements with alternating electrically connected source contacts and electrically connected drain contacts according to some embodiments of the present disclosure.
FIGS. 6A and 6B are schematic plan and cross-sectional views, respectively, illustrating example circuit devices including dual or double layer horizontal memory elements with electrically connected gate structures according to some embodiments of the present disclosure.
FIGS. 7A and 7B are schematic plan and cross-sectional views, respectively, illustrating example circuit devices including triple layer horizontal memory elements with electrically connected gate structures according to some embodiments of the present disclosure.
FIG. 8 is a flowchart diagram illustrating example methods of fabricating circuit devices including horizontal memory elements and logic elements on a same substrate according to some embodiments of the present disclosure.
FIG. 9 illustrates an antifuse-based OTP memory according to a comparative example.

### DETAILED DESCRIPTION OF EMBODIMENTS

Example embodiments are described herein with reference to the accompanying drawings, which may include cross-section illustrations that are schematic illustrations of idealized embodiments (and intermediate structures). The sizes and relative sizes of layers and regions may be exaggerated for clarity. Additionally, variations from the shapes of the illustrations as a result, for example, of manufacturing techniques and/or tolerances, are to be expected. The same reference numerals may be used to refer to the same or similar elements in various embodiments, where reference numerals followed by a dash (-1, -2, etc.) or one or more prime symbols (') may refer to specific instances or variations of the same or similar elements.

In embodiments described herein, a transistor may have a planar structure, or a vertical structure (including stacked transistor structures). Example stacked transistor structures include, but are not limited to, a 3D-stacked field-effect transistor (3DSFET), a fin transistor, a multibridge-channel field-effect transistor (MBCFET^{™}), and a MBCFET^{™} that does not include a bulk silicon substrate (e.g., a bulkless MBCFET) and includes bounded shallow trench isolation (STI) regions.

Some transistor structures may be implemented as a one-time programmable (OTP) memory device, which is a type of non-volatile memory that enables data to be written only once and cannot be subsequently erased or modified. OTP memories may have improved integration and reduced device fabrication processes relative to a multi-time programmable (MTP) memory, such as an electrically erasable programmable read only memory (EEPROM). An OTP memory may include various types of programmable elements, such as an electrical fuse (eFuse) or an antifuse. A default state of an OTP memory including an eFuse (e.g., a strip of metal or polysilicon) may be a logic '0' (or low resistance), and it may be programmed by applying a relatively high density of current that breaks or "blows" the fuse. Accordingly, a read operation may include determining whether the strip is electrically shorted (e.g., a logic '0') or if it is not electrically shorted (e.g., a logic '1').

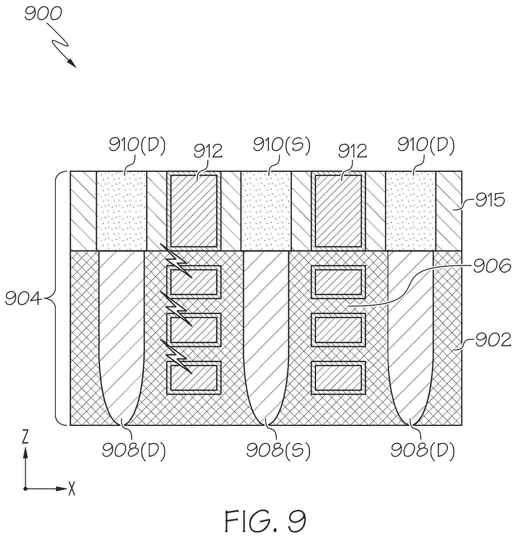

FIG. 9 illustrates an antifuse-based OTP memory 900 according to a comparative example. A default state of an OTP memory 900 including an antifuse may be a logic '1' (or high resistance), and it may be programmed by applying a relatively larger voltage to the thin gate oxide (or other dielectric) to thereby electrically short the gate and source (or drain) of the stacked transistor. Accordingly, a read operation may include determining whether the OTP memory is electrically shorted (e.g., a logic '0') or is not electrically shorted (e.g., a logic '1'). eFuse-based and antifuse-based OTP memories may have varying yield characteristics (e.g., eFuse-based OTP memories have relatively lower yields relative to antifuse-based OTP memories), standby power characteristics (e.g., eFuse-based OTP memories have a logic '1' when it is unprogrammed, while antifuse-based OTP memories have a logic '0' when it is unprogrammed), and/or security characteristics (e.g., it may be relatively easier to visibly observe or detect when eFuse-based OTP memories have been programmed due to the blown fuse, while it may be relatively difficult to externally detect or otherwise determine when the antifuse-based OTP memories have been shorted or programmed).

As shown in FIG. 9, the antifuse-based OTP memory 900 may be formed in a vertically stacked transistor structure 904, which includes at least one channel region 906 extending between source/drain regions 908 (including source region 908(S) and drain region 908(D)) in a substrate 902, with a gate 912 on the channel region(s) 906 and separated from adjacent source/drain contacts 910 (including source contact 910(S) and drain contact 910(D)) on the source/drain regions 908 by a dielectric layer 915. The OTP operation is performed by controlling the breakdown of the gate dielectric layer between the gate 912 and channel patterns 906, in the vertical (e.g., Z-) direction. However, if there is a defect in the gate dielectric (e.g., an undesirable gate dielectric loss value), the OTP memory may malfunction.

Some embodiments of the present disclosure may arise from realization that it may be advantageous to integrate formation of logic and memory elements simultaneously (or otherwise using common fabrication processes) on a same substrate or wafer. For example, a circuit device may include a memory region and a logic region. In the memory region, the source/drain contacts and source/drain regions of the epitaxial semiconductor structure may be electrically isolated by one or more dielectric or insulating spacer layers, whereas in the logic region, the source/drain contacts may be electrically connected to the source/drain regions of the epitaxial semiconductor structure. The spacers may extend between the gate and source/drain contacts in a horizontal or lateral direction (e.g., parallel to an upper surface of the semiconductor structure), such that a memory cell may be formed between the gate and source/drain contacts (with the spacer material therebetween) in the horizontal or lateral direction.

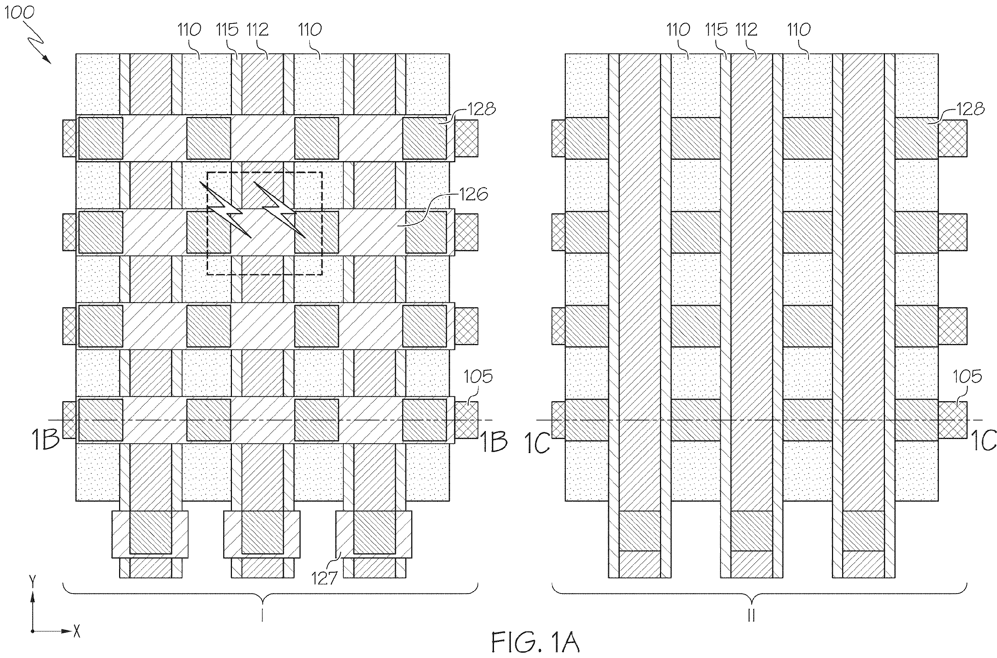

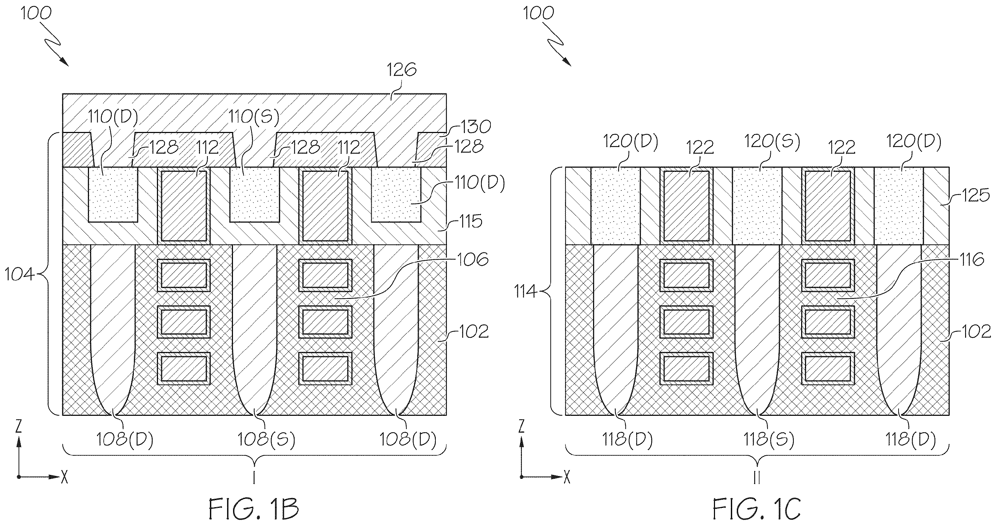

FIG. 1A is a schematic top or plan view and FIGS. 1B and 1C are schematic cross-sectional views (taken along lines 1B-1B and 1C-1C of FIG. 1A, respectively) illustrating example circuit devices including horizontal memory elements and logic elements on a same substrate according to some embodiments of the present disclosure.

As shown in FIGS. 1A to 1C, a circuit device 100 includes a semiconductor substrate 102 having active regions 105 including a memory region I and a logic region II. First transistor structures 104 (e.g., memory elements) are provided in the memory region I of the semiconductor substrate 102, and second transistor structures 114 (e.g., logic elements) are provided in the logic region II of the semiconductor substrate 102 adjacent the memory region I. The semiconductor substrate 102 may include semiconductor material(s), for example, Si, Ge, SiGe, GaP, GaAs, SiC, SiGeC and/or InP and/or may include insulating material(s), for example, silicon oxide, silicon oxynitride, silicon nitride, silicon carbonitride and/or a low-k material. In some embodiments, the semiconductor substrate 102 may include a bulk substrate (e.g., a silicon wafer), or a semiconductor on insulator (SOI) substrate. The memory elements and logic elements may be configured as a planar FET, finFET, GAAFET, and/or a 3DSFET.

Each first transistor structure 104 includes at least one first channel pattern or region 106 extending between first source/drain regions 108 (including source region 108(S) and drain region 108(D)) having first source/drain contacts 110 (including source contact 110(S) and drain contact 110(D)) thereon. Each second transistor structure 114 includes at least one second channel pattern or region 116 extending between second source/drain regions 118 (including source region 118(S) and drain region 118(D)) having second source/drain contacts 120 (including source contact 120(S) and drain contact 120(D)) thereon. The first transistor structures 104 further include a first gate 112 on the at least one first channel region 106, and the second transistor structures 114 further include a second gate 122 on the at least one second channel region 116. The first gates 112 and the second gates 122 continuously extend in a first direction (e.g., the Y-direction), which intersects a second direction of extension of the channel regions 106, 116 (e.g., the X-direction) between the source/drain regions 108, 118. The first channel region(s) 106 (or likewise, the second channel region(s) 116) may include a plurality of channel regions 106 or 116 that are stacked in a third direction (e.g., the Z-direction) that intersects the first and second directions. For example, the first and/or second channel regions 106 and/or 116 may be nanosheets or nanolayers (each of which may have a thickness in a range of about 1 nm to 100 nm in the Z-direction) or may be nanowires (each of which may have a circular cross-section with a diameter in a range of about 1 nm to 100 nm). The number of first channel regions 106 and the number of second channel regions 116 may vary, and may be the same as or different from one another.

In some embodiments, the channel regions 106, 116 may include semiconductor material(s), for example, Si, Ge, SiGe, GaP, GaAs, SiC, SiGeC and/or InP. In some embodiments, the gates 112, 122 may include, for example, tungsten (W), aluminum (Al) and/or copper (Cu), alone or in combination with one or more work function layers, such as, a TiN layer, a TaN layer, a TiAl layer, a TiC layer, a TiAlC layer, a TiAlN layer and/or a WN layer. In some embodiments, the source/drain contacts 110, 120 may include one or more metal layers, for example, W, Al, and/or Cu. However, the materials of the channel layers 106, 116, the gates 112, 122, and the source/drain contacts 110, 120 are not limited to these materials.

As shown in FIG. 1A, the circuit device 100 further includes contact metal lines 126 that extend in the second direction (e.g., the X-direction). The contact metal lines 126 may provide bit lines for the memory elements (provided by the first transistor structures 104) of the circuit device 100 in some embodiments. The circuit device 100 may further include additional metal lines 127 that provide word lines for the memory elements provided by the first transistor structures 104 of the circuit device 100. In some embodiments, the contact metal lines 126 may be electrically connected to one or more of the first source/drain contacts 110, and the additional metal lines 127 may be electrically connected to the first gates 112. In other embodiments, the contact metal lines 126 may be electrically connected to the first gates 112, and the additional metal lines 127 may be electrically connected to one or more of the first source/drain contacts 110. The metal lines 126, 127 may be implemented on a first metallization level or layer (e.g., M1). Respective conductive vias 128 electrically connect the metal lines 126, 127 to the underlying first gates 112 or the first source/drain contacts 110 on a lower metallization level or layer (e.g., M0).

However, as shown in FIG. 1B, first spacers 115 electrically isolate ones of the first source/drain regions 108 from ones of the first source/drain contacts 110 thereon in the memory region I. The first spacers 115 include one or more dielectric materials or layers that extend between the first source/drain contacts 110 and the first source/drain regions 108. The first spacers 115 may further extend between the first gate 112 and the first source/drain contacts 110. As described in greater detail below, the dielectric material(s) or layer(s) may have a thickness, dielectric constant, and/or other physical or electrical characteristics that are configured for dielectric breakdown in response to application of a voltage to the first gates 112 or to the first source/drain contacts 110, thereby providing electrical connection between the first gates 112 and the first source/drain contacts 110 such that the first transistor structures 104 may function as a programmable memory element that is oriented in a horizonal (e.g., X-) direction.

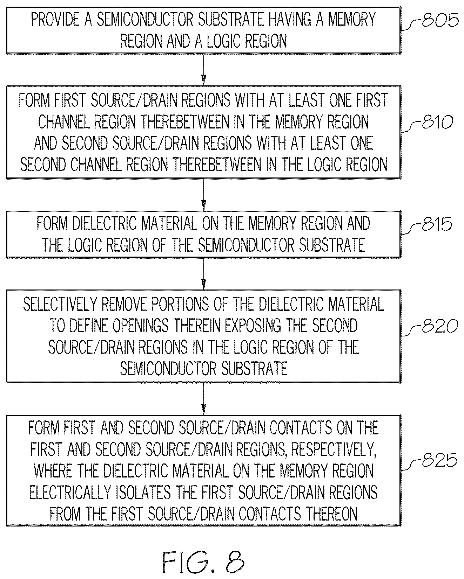

In contrast, as shown in FIG. 1C, second spacers 125 extend between side surfaces of the second gates 122 and the second source/drain contacts 120, but the second source/drain contacts 120 are provided directly on the second source/drain regions 118 in the logic region II, that is, free of spacers 115, 125 between the second source/drain contacts 120 and the second source/drain regions 118. As such, the second transistor structures 114 may function as logic elements or other conventional transistors that conduct electrical current between the second source/drain regions 118 responsive to application of a voltage to the second gates 122. The first transistor structures 104 and the second transistor structures 114 may be fabricated to provide horizontal memory elements and logic elements, respectively, on a same semiconductor substrate 102 using the same or common fabrication processes, as shown in the flowchart diagram of FIG. 8.

As shown in FIGS. 1A, 1B and 1C and FIG. 8, a method of fabricating a circuit device 100 includes providing a semiconductor substrate 102 having a memory region I and a logic region II at block 805, and forming first source/drain regions 108 with at least one first channel region 106 therebetween in the memory region I, and second source/drain regions 118 with at least one second channel region 116 therebetween in the logic region II at block 810. For example, one or more epitaxial growth processes and/or ion implantation processes may be used to form the source/drain regions 108, 118 with the channel regions 106, 116 extending therebetween in the semiconductor substrate 102.

At block 815, one or more dielectric material layers, which may include a contact etch stop layer, may be formed on the memory region I and the logic region II of the semiconductor substrate 102. For example, the dielectric material layer(s) may be deposited on a top surface of the semiconductor substrate 102 or wafer in both the memory region I and the logic region II. The dielectric material(s) may include, but are not limited to, silicon nitride, silicon oxide, aluminum oxide, or hafnium oxide. At block 820, portions of the dielectric material layers may be selectively removed to define openings or contact holes therein exposing the second source/drain regions 118 in the logic region II of the semiconductor substrate 102, for example, using one or more mask patterns and etching processes. During contact hole formation, the contact holes are etched through the overlying dielectric layer(s) down to the surface of the semiconductor substrate 102 in the logic region II, thereby forming the second spacers 125. However, portions of the dielectric material layer(s) may not be completely removed or may selectively remain on the first source/drain regions 108 in the memory region I, thereby forming the first spacers 115.

In some embodiments, the dielectric material layer(s) may include a contact etch stop layer (CESL). The CESL may include a material and/or thickness that is configured to prevent an etchant from excessively etching the semiconductor substrate 102 during contact hole formation, thereby preventing damage to underlying layers. For example, the CESL may include a material that having an etch selectivity to others of the dielectric material layer(s), such as SiN (which provides etch selectivity to SiO layers thereon). The CESL may also be configured to impart mechanical stress to an underlying channel region 106, 116 so as to improve performance (e.g., channel conductivity) in some embodiments.

At block 825, first and second source/drain contacts 110, 120 are formed on the first and second source/drain regions 108, 118, respectively. The second source/drain contacts 120 may be formed directly on the second source/drain regions 118 in the openings in the dielectric material layer(s) in the logic region II with the second spacers 125 therebetween. The first source/drain contacts 110 may likewise be formed on the first source/drain regions 108 in the openings in the dielectric material layer(s) in the memory region I. However, the portions of the dielectric material layer(s) remaining in the memory region I (including remaining portions of the CESL) provide first spacers 115 that extend between the first source/drain regions 108 and the first source/drain contacts 110 thereon in the memory region I.

As such, the first source/drain contacts 110 may not be electrically connected to the first source/drain regions 108 in the memory region I. For example, the first source/drain contacts 110 may be separated and electrically isolated from the epitaxial or implanted first source/drain regions 108 in the memory region I by first spacers 115 (including the remaining portions of the CESL). In the logic region II, the dielectric material layer(s)(including the CESL) may be removed over the epitaxial or implanted second source/drain regions 118, and thus the second source/drain contacts 120 may be directly coupled to the second source/drain regions 118. The composition, layers, and/or dimensions of the first spacers 115 in the memory region I may be selected depending on the intended memory structure/function (e.g., a metal-insulator-metal (MIM) structure for a programmable memory device). That is, the first transistor structures 104 in the memory region I may include first spacers 115 that electrically separate or isolate the first source/drain regions 108 from the first source/drain contacts 110 thereon, while the second transistor structures 114 in the logic region II may be free of the spacers 115, 125 between the second source/drain regions 118 and the second source/drain contacts 120.

First gates 112 may be formed on the first channel regions 106 and second gates 122 may be formed on the second channel regions 116. The first gates 112 and the second gates 122 continuously extend in a first direction, the first channel regions 106 and the second channel regions 116 extend in a second direction intersecting the first direction. The gates 112, 122 may be continuously connected without interruption in a vertical structure. The source/drain contacts 110, 120 may also continuously extend in the first direction, and may be continuously connected without interruption in a vertical structure.

The first spacers 115 may extend (e.g., continuously) along the first direction between the first gates 112 and the first source/drain contacts 110, and may be configured for dielectric breakdown responsive to a voltage (e.g., a program voltage or erase voltage) applied to the first gates 112, so as to provide two or more different resistance states (e.g., based on electrical connection due to the dielectric breakdown) between the first gates 112 and one or more of the first source/drain contacts 110 laterally adjacent thereto. The first transistor structures 104 in the memory region I may thereby provide memory elements between the first gates 112 and the first source/drain contacts 110 in a horizontal direction.

The second spacers 125 may likewise extend (e.g., continuously) along the first direction between the second gates 122 and the second source/drain contacts 120, but may not be configured for dielectric breakdown responsive to a voltage applied to the second gates 122. For example, the second spacers 125 may have a thickness (e.g., in the lateral or X-direction) that is greater than a thickness of the first spacers 115, such that the second spacers 125 may not be configured to breakdown or may not otherwise provide different resistance states between the second gates 122 and the second source/drain contacts 120 laterally adjacent thereto. Additionally or alternatively, a voltage applied to the second gates 122 in the logic region II (e.g., a switching voltage) may be less than a voltage applied to the first gates 112 in the memory region I (e.g., a program or erase voltage), such that the second spacers 125 may not breakdown in response to the voltage applied to the second gates 122. The second transistor structures 114 in the logic region II may thereby provide logic elements that conventionally provide electrical connection between the second source/drain regions 118 responsive to a voltage applied to the second gates 122.

Contact metal lines 126 may be formed continuously extending in the second direction, for example, at a first metallization (e.g., M1) layer that is higher or above the layers of the source/drain contacts 110, 120 and the gates 112, 122 (e.g., M0). The contact metal lines 126 may be electrically connected to ones of the first source/drain contacts 110, or may be connected to the first gates 112 in some embodiments, by respective conductive vias 128 that extend from the upper metallization layer M1 to the lower metallization layer M0, through one or more insulating layers 130. The memory elements (as provided by the first transistor structures 104) and the logic elements (as provided by the second transistor structures 114) may thereby be fabricated simultaneously or using the same processes, and such that the first transistor structures 104 providing the memory elements can be operated or controlled through metal lines 126, 127 of an interconnect metal layer M1.

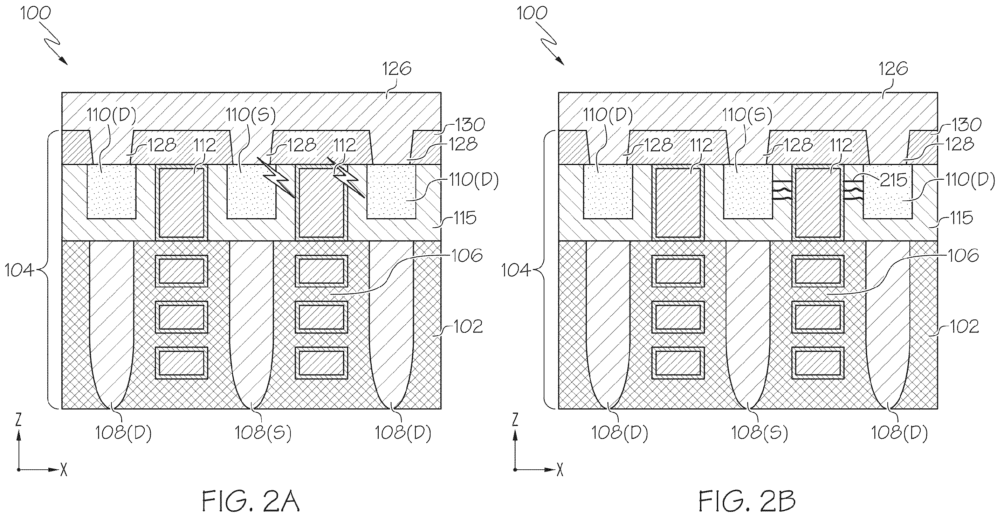

FIGS. 2A and 2B are schematic cross-sectional views (taken along line 1B-1B of FIG. 1A) illustrating example operational states of first transistor structures 104 providing horizontal memory elements including first source/drain regions 108 connected by a contact metal line 126 in the circuit device 100 of FIGS. 1A-1C. As shown in FIGS. 2A and 2B, the first transistor structure 104 in the memory region I includes a plurality of first channel regions 106 (e.g., a plurality of stacked nanosheets) extending between first source/drain regions 108, first source/drain contacts 110 on the first source/drain regions 108, respectively, and first gates 112 on the channel regions 106 between the first source/drain contacts 110. The first gates 112 continuously extend in a first (e.g., Y-) direction, and a contact metal line 126 extends in a second (e.g., X-) direction and is electrically connected to the first source/drain contacts 110. First spacers 115 electrically isolate the first source/drain regions 108 from the first source/drain contacts 110 thereon in the memory region I.

As noted above, the first spacers 115 include one or more dielectric materials or layers that extends between the first source/drain contacts 110 and the first source/drain regions 108, and further extend between the first gate 112 and the first source/drain contacts 110. In the memory region, the dielectric material is configured (e.g., based on thickness and/or material characteristics) to break down in response to an applied voltage, which may thereby electrically connect the first gates 112 to the first source/drain contacts 110. For example, the dielectric material may have a thickness, dielectric constant, and/or other physical or electrical characteristics that are configured for dielectric breakdown in response to application of the voltage to the first gates 112 or to the first source/drain contacts 110, thereby providing a current path therebetween. The dielectric material(s) may include (but are not limited to) silicon nitride, silicon oxide, aluminum oxide, or hafnium oxide in some embodiments.

The dielectric material of the first spacers 115 is configured to break down in response to a predetermined applied voltage to function as a memory element. The applied voltage may be a voltage difference between a voltage applied to a selected first gate 112 and a voltage applied to the first source/drain contacts 110 (e.g., by a word line 127 and a bit line 126, respectively, or vice versa). The applied voltage (e.g., a program voltage or an erase voltage) may be selected to be greater than an operating voltage (e.g., a switching voltage) of the devices in the logic region II, such that the same dielectric materials and/or thicknesses may be used for the spacers 115, 125 (which may be formed from a contact etch stop layer, as described above) in both the memory region I and the logic region II in some embodiments.

As shown in FIG. 2A, in an initial or default state, the first spacers 115 may electrically isolate the first gates 112 from the first source/drain contacts 110, such that a high resistance (e.g., a logic '1') is provided therebetween. For example, in the initial or default state of the first transistor structure 104, a bit line 126 (which is electrically connected to multiple of the first source/drain contacts 110 in FIG. 2A) and a word line 127 (which is electrically connected to a selected one of the first gates 112; *see* FIG. 1A) may be provided in an electrically floating state, such that the dielectric properties of the first spacers 115 provide an initial or default electrical resistance between the selected first gate 112 and the adjacent first source/drain contacts 110.

As shown in FIG. 2B, in program state, a voltage that is sufficient to break down the dielectric material of the first spacers 115 may be applied to the selected first gate 112, so as to electrically short the first gate 112 and the first source/drain contacts 110, such that a low resistance (e.g., a logic '0') is provided therebetween. For example, in the program state of the first transistor structure 104, the bit line 126 (which is electrically connected to multiple of the first source/drain contacts 110 in FIG. 2B) may be electrically grounded, and a program bias of greater than 0 V may be applied to a word line 127 (which is electrically connected to a selected one of the first gates 112; *see* FIG. 1A), thereby inducing dielectric breakdown 215 of the first spacers 115 and providing an electrical current path (and thus an electrical resistance that is different than the initial or default electrical resistance) between the selected first gate 112 and the adjacent first source/drain contacts 110.

In the examples of FIGS. 2A and 2B, multiple first source/drain contacts 110 are electrically connected by the contact metal line 126, such that the first spacers 115 on opposing sides of a selected first gate 112 are configured for dielectric breakdown. Accordingly, in response to the selected first gate 112 being biased with the relatively larger program voltage via the word line 127 and the first source/drain contacts 110 being grounded via the bit line 126, the first spacers 115 on opposing first and second sides of the selected first gate 112 can be subjected to dielectric breakdown to provide the electrical resistance for the program state. A read operation may include determining whether the selected first gate 112 and the first source/drain contacts 110 adjacent thereto are electrically shorted or otherwise have the low-resistance state (e.g., a logic '0') or are not electrically shorted or otherwise have the high-resistance state (e.g., a logic '1'), for example, responsive to a read voltage applied via the corresponding bit line 126 and/or word line 127.

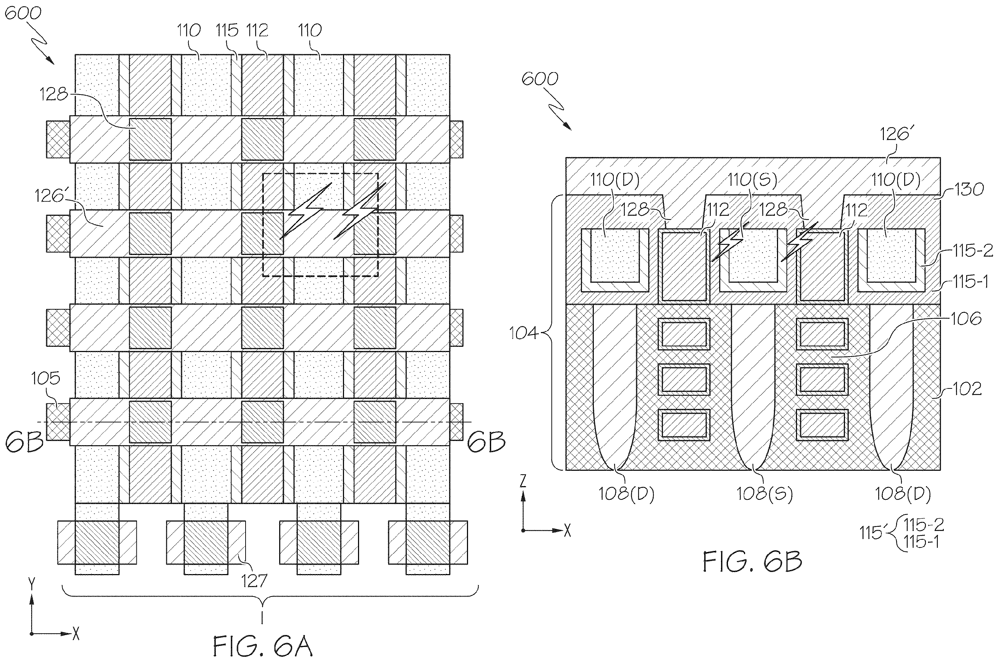

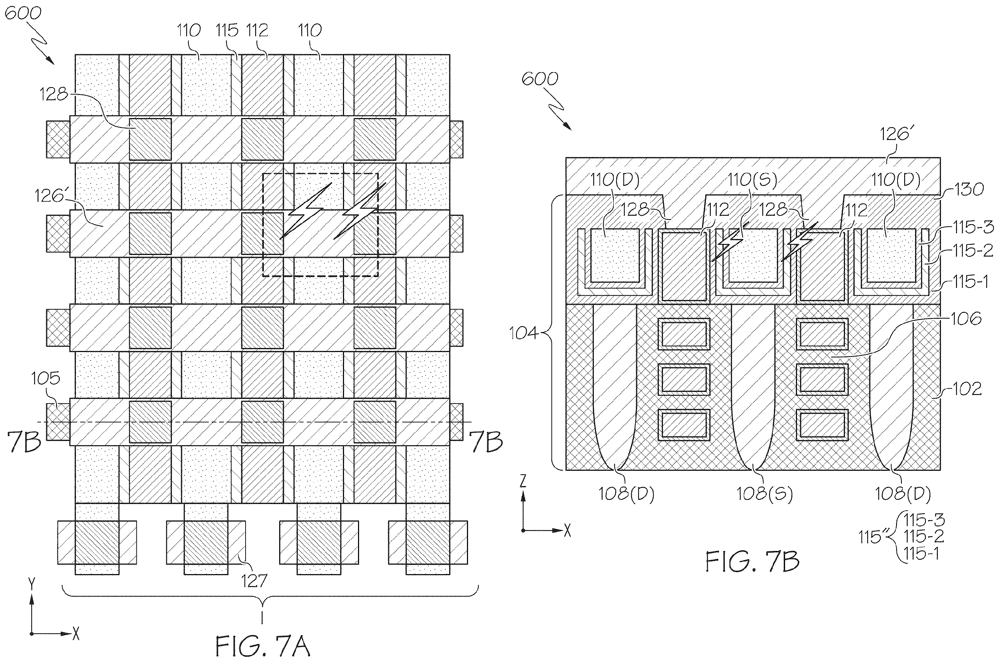

While illustrated in FIGS. 2A and 2B as a one-time programmable circuit device 100 having only two resistance states by way of example, it will be understood that in some embodiments, the first spacers 115 may be configured to provide more than one different electrical resistance states between the first gates 112 and the first source/drain contacts 110 (e.g., depending on the number, thicknesses, and/or compositions of sublayers of the dielectric material of the first spacers 115), as described in greater detail below with reference to FIGS. 6B and 7B. Also, it will be understood that the first gates 112 may be coupled to the bit line 126 and the first source/drain contacts 110 may be coupled to word line 127 in some embodiments.

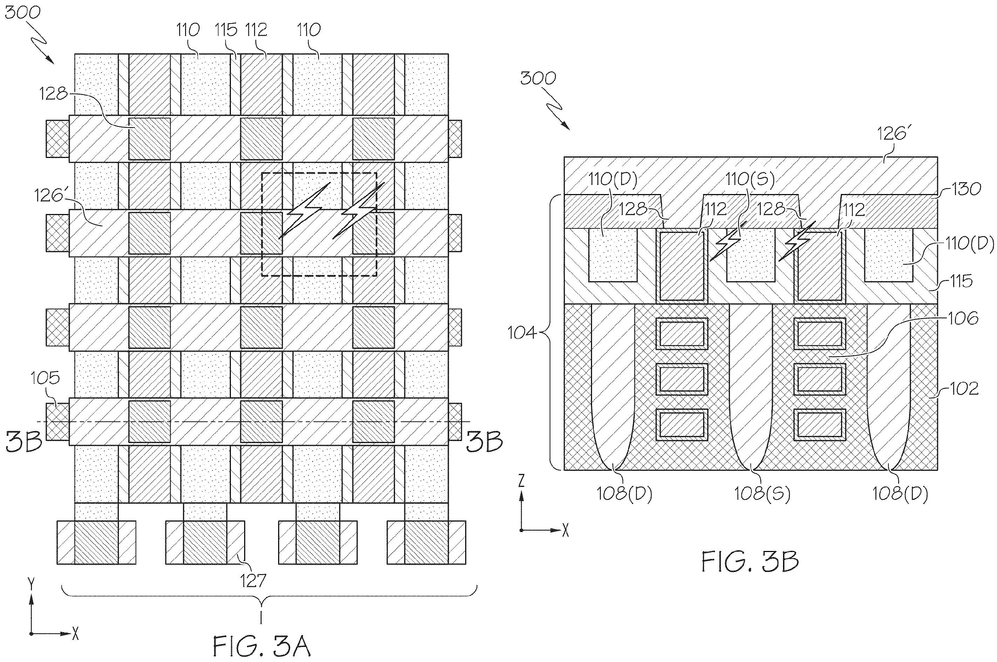

FIGS. 3A and 3B are schematic plan view and a schematic cross-sectional view (taken along line 3B-3B of FIG. 3A), respectively, illustrating an example circuit device 300 including horizontal memory elements with electrically connected gate structures according to some embodiments of the present disclosure. The circuit device 300 may include first transistor structures 104 in a memory region I, and second transistor structures 114 in a logic region II (not shown), similar to the circuit device 100 of FIGS. 1A-1C. However, as shown in FIGS. 3A and 3B, a contact metal line 126' (e.g., a bit line) electrically connects the first gate 112 of the first transistor structure 104 to a respective first gate 112 of one or more adjacent first transistor structures 104' in the memory region I of the semiconductor substrate 102.

That is, in the examples of FIGS. 3A and 3B, multiple first gates 112 are electrically connected by the contact metal line 126', such that the first spacers 115 on opposing sides of each first source/drain contact 110 between adjacent pairs of the first gates 112 are configured for dielectric breakdown. Accordingly, in response to applying a relative larger program voltage or program bias to a selected one of the first source/drain contacts 110 (via a word line 127) and electrically grounding the first gates 112 (via the bit line 126'), the first spacers 115 on opposing first and second sides of the selected first source/drain contact 110 can be subjected to dielectric breakdown to provide the electrical resistance for the program state. A read operation may include determining whether the selected first source/drain contact 110 and the first gates 112 adjacent thereto are electrically shorted or otherwise have the low-resistance state (e.g., a logic '0') or are not electrically shorted or otherwise have the high-resistance state (e.g., a logic '1'), for example, responsive to a read voltage applied via the corresponding bit line 126' and/or word line 127.

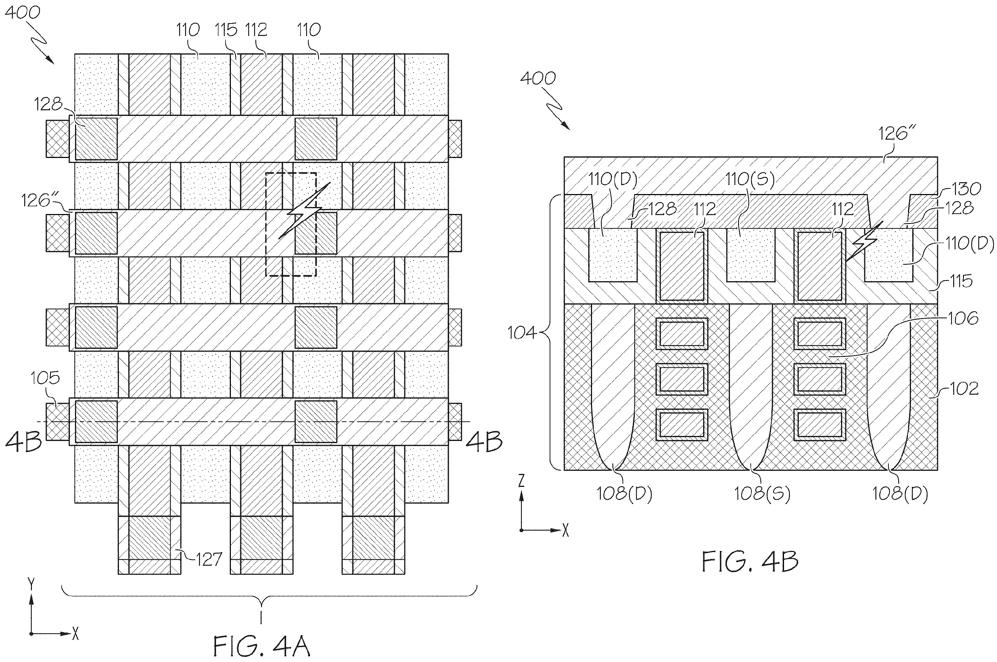

FIGS. 4A and 4B are schematic plan view and a schematic cross-sectional view (taken along line 4B-4B of FIG. 4A), respectively, illustrating an example circuit device 400 including horizontal memory elements with elements with electrically connected drain contacts (or source contacts) according to some embodiments of the present disclosure. The circuit device 400 may include first transistor structures 104 in a memory region I, and second transistor structures 114 in a logic region II (not shown), similar to the circuit device 100 of FIGS. 1A-1C. However, as shown in FIGS. 4A and 4B, a contact metal line 126" (e.g., a bit line) electrically connects the drain contact 110 of the first transistor structure 104 to a respective drain contact 110 of one or more adjacent first transistor structures 104' in the memory region I of the semiconductor substrate 102. While not illustrated, it will be understood that a source contact 110 of the first transistor structure 104 may be similarly electrically connected to a respective source contact 110 of one or more adjacent first transistor structures 104' in the memory region I of the semiconductor substrate 102 in other embodiments.

That is, in the examples of FIGS. 4A and 4B, multiple first drain contacts 110 (or multiple first source contacts 110) are electrically connected by the contact metal line 126", such that the first spacer 115 on one side of a selected first gate 112 is configured for dielectric breakdown. Accordingly, in response to the selected first gate 112 being biased with the relatively larger program voltage (via the word line 127 connected thereto) and the drain contacts 110 (or first source contacts 110) being grounded (via the bit line 126" connected thereto), the spacer 115 on one first side of the selected first gate 112 can be subjected to dielectric breakdown to provide the electrical resistance for the program state. A read operation may include determining whether the selected first gate 112 and the first drain (or source) contact 110 adjacent thereto are electrically shorted or otherwise have the low-resistance state (e.g., a logic '0') or are not electrically shorted or otherwise have the high-resistance state (e.g., a logic '1'), for example, responsive to a read voltage applied via the corresponding bit line 126" and/or word line 127.

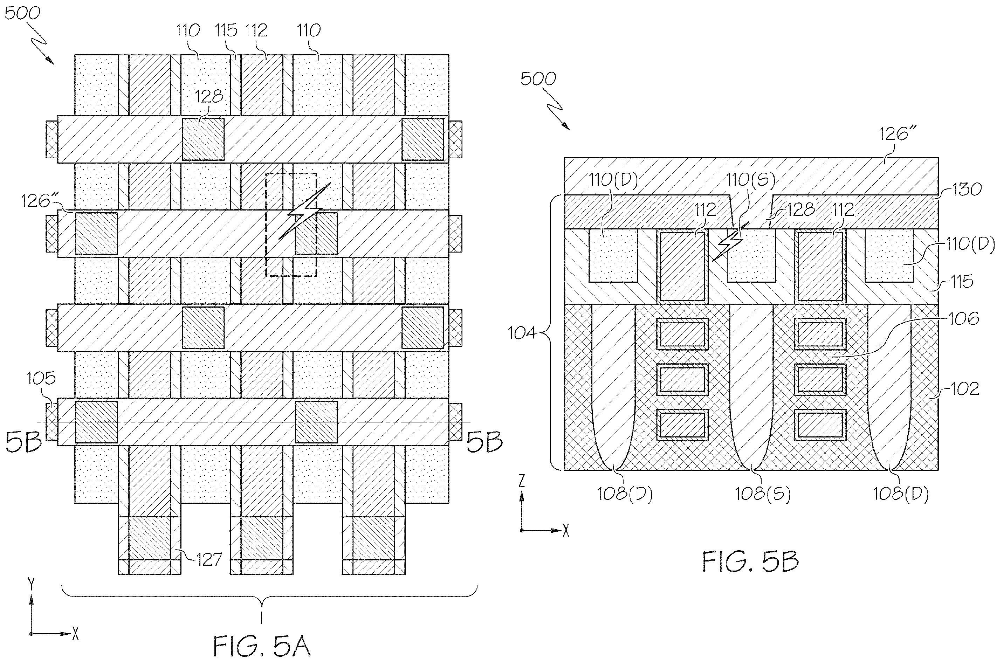

FIGS. 5A and 5B are schematic plan view and a schematic cross-sectional view (taken along line 5B-5B of FIG. 5A), respectively, illustrating an example circuit device 500 including horizontal memory elements with alternating electrically connected source regions and connected drain regions (e.g., using a "zig-zag" arrangement of conductive vias 128) according to some embodiments of the present disclosure. The circuit device 500 may include first transistor structures 104 in a memory region I, and second transistor structures 114 in a logic region II (not shown), similar to the circuit device 100 of FIGS. 1A-1C. However, as shown in FIGS. 5A and 5B, a first contact metal line 126" (e.g., a first bit line) electrically connects the source contact 110 of the first transistor structure 104 to a respective source contact 110 of one or more adjacent first transistor structures 104' in the memory region I of the semiconductor substrate 102, and a second contact metal line 126" (e.g., a second bit line) electrically connects the drain contact 110 of a first transistor structure 104 to a respective drain contact 110 of one or more adjacent first transistor structures 104' in the memory region I of the semiconductor substrate 102. For example, the first and second bit lines 126" may be arranged in alternating rows, as shown in the plan view of FIG. 5A.

That is, in the examples of FIGS. 5A and 5B, multiple first source contacts 110 (and multiple first drain contacts 110) are electrically connected by respective contact metal lines 126", such that the first spacer 115 on one side of a selected first gate 112 is configured for dielectric breakdown. Accordingly, in response to the selected first gate 112 being biased with the relatively larger program voltage (via the word line 127 connected thereto) and the first source contacts 110 (or first drain contacts 110) being grounded (via a corresponding bit line 126" connected thereto), the spacer 115 on one first side of the selected first gate 112 can be subjected to dielectric breakdown to provide the electrical resistance for the program state. A read operation may include determining whether the selected first gate 112 and the first source (or drain) contact 110 adjacent thereto are electrically shorted or otherwise have the low-resistance state (e.g., a logic '0') or are not electrically shorted or otherwise have the high-resistance state (e.g., a logic '1'), for example, responsive to a read voltage applied via the corresponding bit line 126" and/or word line 127.

FIGS. 6A and 6B are schematic plan view and a schematic cross-sectional view (taken along line 6B-6B of FIG. 6A), respectively, illustrating an example circuit device 600 including dual or double dielectric layer horizontal memory elements with electrically connected gate structures according to some embodiments of the present disclosure. The circuit device 600 may include first transistor structures 104 in a memory region I, and second transistor structures 114 in a logic region II (not shown), similar to the circuit device 300 of FIGS. 3A and 3B, with a contact metal line 126' (e.g., a bit line) that electrically connects the first gate 112 of the first transistor structure 104 to a respective first gate 112 of one or more adjacent first transistor structures 104' in the memory region I of the semiconductor substrate 102. That is, in the examples of FIGS. 6A and 6B, multiple first gates 112 are electrically connected by the contact metal line 126', such that the first spacers 115 on opposing sides of each first source/drain contact 110 between adjacent pairs of the first gates 112 are configured for dielectric breakdown.

However, as shown in FIGS. 6A and 6B, rather than single-layer first spacers 115, multi-layer spacers 115' are provided to electrically isolate the first source/drain contacts 110 from the first source/drain regions 108 (and extending between the first source/drain contacts 110 and the first gates 112). The multi-layer spacers 115' include a first dielectric layer 115-1 and a second dielectric layer 115-2. The first dielectric layer 115-1 may include or may be formed of a different dielectric material than the second dielectric layer 115-2. The dielectric material(s) may include, but are not limited to, silicon nitride, silicon oxide, aluminum oxide, or hafnium oxide. For example, the first dielectric layer 115-1 may include silicon oxide, while the second dielectric layer 115-2 may include silicon nitride, or vice versa. The first dielectric layer 115-1 or the second dielectric layer 115-2 may be a same material as the insulating layer(s) 130 in some embodiments.

For example, prior to forming the first source/drain contacts 110, the first dielectric layer 115-1 may be formed on the surface of the semiconductor substrate 102, and portions of the first dielectric layer 115-1 may be selectively removed to define openings therein. The openings may expose the second source/drain regions 118 in the logic region II, but do not expose the first source/drain regions 108 in the memory region I. A second dielectric layer 115-2 may be formed in the openings in the first dielectric layer 115-1 in the memory region I (where the second dielectric layer 115-2 includes a different dielectric material than the first dielectric layer 115-1) prior to forming the first source/drain contacts 110 therein.

The first and second dielectric layers 115-1 and 115-2 may be configured to provide multiple resistance states. For example, the first dielectric layer 115-1 may have a material composition and/or thickness that is configured for dielectric breakdown in response to electrically grounding the first gates 112 (via the bit line 126') and applying a first voltage to a selected one of the first source/drain contacts 110 (via a word line 127). Similarly, the second dielectric layer 115-2 may have a different material composition and/or thickness that is configured for dielectric breakdown in response to electrically grounding the first gates 112 (via the bit line 126') and applying a second voltage to the selected one of the first source/drain contacts 110 (via a word line 127), where the second voltage is different from the first voltage.

Dielectric breakdown of the first dielectric layer 115-1 may provide a first resistance state, dielectric breakdown of the second dielectric layer 115-2 may provide a second resistance state, and dielectric breakdown of both the first dielectric layer 115-1 and the second dielectric layer 115-2 may provide a third resistance state that is different from the first or second resistance states, in response to application of the first and/or second voltages. The first dielectric layer 115-1 and the second dielectric layer 115-2 may collectively provide a fourth resistance state, prior to dielectric breakdown of either layer 115-1 or 115-2.

Accordingly, one or more of the first dielectric layer 115-1 and the second dielectric layer 115-2 on opposing first and second sides of the selected first source/drain contact 110 can be subjected to dielectric breakdown to provide multiple electrical resistances for respective program states. A read operation may include determining which of the respective electrical resistances are provided between the selected first source/drain contact 110 and the first gates 112 adjacent thereto, for example, responsive to a read voltage applied via the corresponding bit line 126' and/or word line 127.

FIGS. 7A and 7B are schematic plan view and a schematic cross-sectional view (taken along line 7B-7B of FIG. 7A), respectively, illustrating an example circuit device 700 including triple layer horizontal memory elements with electrically connected gate structures according to some embodiments of the present disclosure. The circuit device 700 may include first transistor structures 104 in a memory region I, and second transistor structures 114 in a logic region II (not shown), similar to the circuit device 300 of FIGS. 3A and 3B, with a contact metal line 126' (e.g., a bit line) that electrically connects the first gate 112 of the first transistor structure 104 to a respective first gate 112 of one or more adjacent first transistor structures 104' in the memory region I of the semiconductor substrate 102. That is, in the examples of FIGS. 7A and 7B, multiple first gates 112 are electrically connected by the contact metal line 126', such that the first spacers 115 on opposing sides of each first source/drain contact 110 between adjacent pairs of the first gates 112 are configured for dielectric breakdown.

However, as shown in FIGS. 7A and 7B, rather than single-layer first spacers 115, multi-layer spacers 115" are provided to electrically isolate the first source/drain contacts 110 from the first source/drain regions 108 (and extending between the first source/drain contacts 110 and the first gates 112). The multi-layer spacers 115" include a first dielectric layer 115-1, a second dielectric layer 115-2, and a third dielectric layer 115-3. The first dielectric layer 115-1 may include or may be formed of a different dielectric material than the second dielectric layer 115-2. The third dielectric layer 115-3 may also include or may be formed of a different dielectric material than the second dielectric layer 115-2. The first dielectric layer 115-1 and the third dielectric layer 115-3 may be formed of the same dielectric material(s), or may be formed of different dielectric materials. For example, the first dielectric layer 115-1 may include silicon oxide, the second dielectric layer 115-2 may include silicon nitride, and the third dielectric layer 115-3 may include silicon oxide, providing an oxide-nitride-oxide (ONO) layer structure between the selected first source/drain contact 110 and the first gates 112 adjacent thereto. The first dielectric layer 115-1, the second dielectric layer 115-2, or the third dielectric layer 115-3 may be a same material as the insulating layer(s) 130 in some embodiments.

For example, prior to forming the first source/drain contacts 110, the first dielectric layer 115-1 may be formed on the surface of the semiconductor substrate 102, and portions of the first dielectric layer 115-1 may be selectively removed to define openings therein. The openings may expose the second source/drain regions 118 in the logic region II, but do not expose the first source/drain regions 108 in the memory region I. A second dielectric layer 115-2 and a third dielectric layer 115-3 may be formed in the openings in the first dielectric layer 115-1 in the memory region I prior to forming the first source/drain contacts 110 therein.

The first, second, and third dielectric layers 115-1, 115-2, and 115-3 may be configured to provide multiple resistance states. For example, each of the first dielectric layer 115-1, the second dielectric layer 115-2, and the third dielectric layer 115-3 may have a respective material composition and/or thickness that is configured for dielectric breakdown in response to application of a first, second, or third voltage, respectively, to the selected one of the first source/drain contacts 110 (e.g., via a word line 127, while electrically grounding the first gates 112 via the bit line 126'). Dielectric breakdown of each of the first dielectric layer 115-1, the second dielectric layer 115-2, and the third dielectric layer 115-3 may provide a different first resistance state, a second resistance state, and a third resistance state, respectively, while dielectric breakdown of combinations of the first dielectric layer 115-1, the second dielectric layer 115-2, and the third dielectric layer 115-3 may provide respective different resistance states. The first dielectric layer 115-1, the second dielectric layer 115-2, and the third dielectric layer 115-3 may also collectively provide another resistance state, prior to dielectric breakdown of any of the layers 115-1, 115-2, or 115-3.

Accordingly, one or more of the first dielectric layer 115-1, the second dielectric layer 115-2, and the third dielectric layer 115-3 on opposing first and second sides of the selected first source/drain contact 110 can be subjected to dielectric breakdown to provide multiple electrical resistances for respective program states. A read operation may include determining which of the respective electrical resistances are provided between the selected first source/drain contact 110 and the first gates 112 adjacent thereto, for example, responsive to a read voltage applied via the corresponding bit line 126' and/or word line 127.

That is, as shown in FIGS. 6A-6B and 7A-7B, the first spacers may be implemented by multi-layer spacers 115', 115" including two or more dielectric sublayers 115-1, 115-2, and/or 115-3 (e.g., two layers, three layers, and so on). In some embodiments, the characteristics of the multi-layer spacers 115', 115" are configured such that the circuit device 600, 700 forms a MIM structure, such as a resistive-type memory (e.g., an RRAM). As an example, the characteristics (e.g., material composition and/or thickness) of the sublayers 115-1, 115-2, and/or 115-3 of the multi-layer spacers 115', 115" may be defined to control the magnitude of the dielectric breakdown thereof in response to a respective voltage, thereby allowing the circuit devices 600, 700 to operate as a multi-state or re-programmable memory device (rather than an OTP memory).

Advantages of structures, features, or operations disclosed herein, and with reference to any one of the example embodiments, either alone or in any combination thereof, the memory array and the logic components may be fabricated on a single wafer with improved/higher integration or density and using the same or compatible fabrication processes. Furthermore, by defining the configuration (including the number of dielectric layers and the material compositions thereof) of the spacers and/or controlling the voltage differences between the word lines and bit lines (to selectively induce and control the magnitude of dielectric breakdown between the gate and the source/drain contacts that are coupled to the word lines and bit lines, or vice versa), the circuit devices described herein can be configured to operate as an OTP memory device or a (re-) programmable memory device (e.g., a resistive-type programmable memory). That is, some embodiments may allow for fabrication of memory elements and logic elements on a same wafer using the same or compatible fabrication processes, for OTP or re-programmable memory applications. Additionally, as the memory elements and the logic elements may have substantially similar structures (e.g., other than the presence or absence of the spacer between the source/drain contacts and the source/drain regions), a higher density may be achieved (compared to SRAM devices). Also, a contact metal line (which may be electrically connected to either the gates or the source/drain contacts) may be connected to the bit line, allowing for voltage application. The voltage difference between the word line and bit line can induce dielectric breakdown of the dielectric spacer between the gate contacts and the source/drain contacts, so as to function as an OTP memory or as a resistive-type programmable memory, depending on the configuration of the dielectric spacer.

Unless otherwise defined, all terms used herein have the same meaning as commonly understood by one of ordinary skill in the art. Further, all terms should be interpreted as having a meaning that is consistent with their meaning in the context of the relevant art and this disclosure and will not be interpreted in an idealized or overly formal sense unless expressly so defined herein.

In the description above, example embodiments may be described with reference to regions of particular conductivity types. It will be appreciated that opposite conductivity type devices may be formed by simply reversing the conductivity of the n-type and p-type layers in each of the above embodiments. Thus, it will be appreciated that the present disclosure covers both n-channel and p-channel devices for each different device structure.

The terminology used herein is for the purpose of describing particular embodiments only and is not intended to be limiting of embodiments. The singular forms "a," "an," and "the" are intended to include the plural forms as well, unless the context clearly indicates otherwise. The terms "comprises," "comprising," "includes" and/or "including" specify the presence of the stated features, steps, operations, elements, components and/or groups, but do not preclude the presence or addition of one or more other features, steps, operations, elements, components and/or groups thereof.

It will be understood that, although the terms "first," "second," etc. may be used throughout this specification to describe various elements, these elements should not be limited by these terms. Rather, these terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

The terms "surround" or "cover" or "fill" as used herein may not require completely surrounding or covering or filling the described elements or layers, but may, for example, refer to partially surrounding or covering or filling the described elements or layers. Components or layers described with reference to "overlap" in a particular direction may be at least partially obstructed by one another when viewed along a line extending in the particular direction or in a plane perpendicular to the particular direction.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. The term "connected" may include physical and/or electrical connections.

Spatially relative terms such as "below" or "above" or "upper" or "lower" or "top" or "bottom" or "side" may be used herein to describe a relationship of one element, layer or region to another element, layer or region based on a frame of reference (e.g., a substrate), as illustrated in the figures. It will be understood that these terms are intended to encompass different orientations of the device in addition to the orientation depicted in the figures.

Example embodiments are described herein with reference to the accompanying drawings, which may include cross-section illustrations that are schematic illustrations of idealized embodiments (and intermediate structures). Many different forms and embodiments are possible without deviating from the teachings of this disclosure. Accordingly, the present disclosure should not be construed as limited to the example embodiments set forth herein. As such, it will be understood by those of ordinary skill in the art that various changes in form and details may be made therein without departing from the scope as defined herein. In the drawings, the sizes and relative sizes of layers and regions may be exaggerated for clarity. Additionally, variations from the shapes of the illustrations as a result, for example, of manufacturing techniques and/or tolerances, are to be expected.

Embodiments of the present disclosure are also described with reference to fabrication operations and flowchart diagrams. It will be appreciated that the steps shown in the fabrication operations and flowchart diagrams need not be performed in the order shown.

## Claims

1. A circuit device, comprising:
a semiconductor substrate comprising a first transistor structure, wherein the first transistor structure comprises:
at least one first channel region extending between first source/drain regions;
first source/drain contacts on the first source/drain regions, respectively;
a first gate on the at least one first channel region between the first source/drain contacts; and
a first spacer that electrically isolates one of the first source/drain regions from one of the first source/drain contacts thereon.

2. The circuit device of Claim 1, wherein the first spacer comprises a dielectric material that extends between the one of the first source/drain contacts and the one of the first source/drain regions, and further extends between the first gate and the one of the first source/drain contacts, wherein the dielectric material may comprise silicon nitride, silicon oxide, aluminum oxide, or hafnium oxide.

3. The circuit device of Claim 2, wherein the dielectric material comprises a first dielectric layer and a second dielectric layer comprising a different dielectric material than the first dielectric layer.

4. The circuit device of Claim 3, wherein the dielectric material further comprises a third dielectric layer comprising a different dielectric material than the second dielectric layer, and the second dielectric layer is between the first dielectric layer and the third dielectric layer.

5. The circuit device of any one of Claims 2 to 4, wherein the first gate continuously extends in a first direction, at least one first channel region extends between the first source/drain regions in a second direction intersecting the first direction, and further comprising:
a contact metal line that extends in the second direction and is electrically connected to one selected from a group consisting of the first gate and the one of the first source/drain contacts.

6. The circuit device of Claim 5, wherein the first spacer comprises respective first spacers that extend between the first gate and the first source/drain contacts, and the contact metal line electrically connects the first source/drain contacts.

7. The circuit device of Claim 5, wherein the contact metal line electrically connects the first gate of the first transistor structure to a respective gate of at least one adjacent transistor structure in the semiconductor substrate.

8. The circuit device of Claim 5 or 6, wherein the contact metal line electrically connects the one of the first source/drain contacts to a respective source/drain contact of at least one adjacent transistor structure in the semiconductor substrate.

9. The circuit device of any one of Claims 5 to 8, wherein the contact metal line comprises a bit line of the circuit device, and the circuit device further comprising:
a word line that is electrically connected to another selected from the group consisting of the first gate and the one of the first source/drain contacts,
wherein the dielectric material is configured to break down in response to an applied voltage comprising a difference between a voltage applied to the bit line and a voltage applied to the word line.

10. The circuit device of any one of Claims 1 to 9, wherein the first transistor structure is in a memory region of the semiconductor substrate, wherein the semiconductor substrate further comprises:
a second transistor structure in a logic region of the semiconductor substrate that is adjacent the memory region, the second transistor structure comprising at least one second channel region extending between second source/drain regions having second source/drain contacts directly thereon, respectively.

11. The circuit device of Claim 10, wherein the second transistor structure further comprises a second gate on the at least one second channel region, wherein the first gate and the second gate continuously extend the same direction.

12. A method of fabricating a circuit device, the method comprising:
providing a semiconductor substrate having a memory region and a logic region;
forming first source/drain regions with at least one first channel region therebetween in the memory region and second source/drain regions with at least one second channel region therebetween in the logic region;
forming a dielectric material on the memory region and the logic region of the semiconductor substrate; and
forming first and second source/drain contacts on the first and second source/drain regions, respectively,
wherein the dielectric material on the memory region provides first spacers that electrically isolate the first source/drain regions from the first source/drain contacts thereon, and
wherein the dielectric material may comprise silicon nitride, silicon oxide, aluminum oxide, or hafnium oxide.

13. The method of Claim 12, further comprising:
selectively removing portions of the dielectric material to define openings therein exposing the second source/drain regions in the logic region of the semiconductor substrate,
wherein forming the first and second source/drain contacts comprises forming the second source/drain contacts in the openings in the dielectric material and directly on the second source/drain regions, respectively.

14. The method of Claim 13, further comprising:
forming a first gate on the at least one first channel region and a second gate on the at least one second channel region,
wherein the first spacers extend between the first source/drain contacts and the first source/drain regions, and further extend between the first gate and the first source/drain contacts.

15. The method of Claim 14, wherein the first gate and the second gate continuously extend in a first direction, the at least one first channel region and the at least one second channel region extend in a second direction intersecting the first direction, and further comprising:
forming a contact metal line that extends in a second direction and is electrically connected to one selected from a group consisting of the first gate and one of the first source/drain contacts.
